# EUROPÄISCHE PATENTSCHRIFT

(11) **EP 0 400 434 B1**
(45) Veröffentlichungstag und Bekanntmachung des Hinweises auf die Patenterteilung: **23.03.1994**
(21) Anmeldenummer: 90109549.7
(22) Anmeldetag: 19.05.1990
(51) Int. Cl.: H05K 5/06

(54) **Gehäuse zum Anschluss eines elektrischen Bausteins, insbesondere eines Relais, an elektrische Leitungen in der Bordelektronik von Fahrzeugen**
Casing for connecting an electric component particularly a relay to electric vehicle dashboard conductors
Boîtier pour la connection d'un composant électrique, en particulier d'un relais, aux conducteurs électriques du tableau de bord d'un véhicule

(30) Priorität: 02.06.1989 DE 3918056
(43) Veröffentlichungstag der Anmeldung: 05.12.1990
(73) Patentinhaber: Kabelwerke Reinshagen GmbH, D-42369 Wuppertal (DE)
(72) Erfinder: Model, Michael, Dipl.-Ing., D-5805 Breckerfeld (DE)
(74) Vertreter: Priebisch, Rüdiger, Dipl.-Ing., Dipl.-Wirtsch.-Ing. (FH)

(56) Entgegenhaltungen:
- DE-B- 1 103 430
- GB-A- 2 061 621
- US-A- 2 847 498

## Beschreibung

Die Erfindung richtet sich auf ein Anschlußgehäuse der im Oberbegriff von Anspruch 1 angegebenen Art; (siehe z.B. DE-B-1 103 430). Bei der bekannten Vorrichtung ist der Relaisbaustein ins Montagegehäuse integriert. Ist das Relais defekt, so wird es mit dem Montageteil weggeworfen. Diese Verschwendung ist kostspielig und belastet die Umwelt. Ferner sind für verschiedene Typen von Relaisbausteinen sowie für Bausteine mit abweichender Stromstärke unterschiedliche Anschlußgehäuse erforderlich, deren Herstellung sowie Lagerhaltung kostenaufwendig und unübersichtlich ist.

Der Erfindung liegt die Aufgabe zugrunde, ein preiswertes Anschlußgehäuse der im Oberbegriff von Anspruch 1 genannten Art zu entwickeln, das den jeweiligen, vom verwendeten Baustein bestimmten Bedürfnissen schnell und zuverlässig angepaßt werden kann. Dies wird erfindungsgemäß durch die im Kennzeichen des Anspruches 1 angeführten Maßnahmen erreicht, denen folgende besondere Bedeutung zukommt:
Das zweiteilige, zur Aufnahme des Bausteins dienende Anschlußgehäuse kann in eine Vielzahl von unterschiedlichen Gehäusegrößen eingestellt werden, in Abhängigkeit von dem zwischen ihnen aufzunehmenden Baustein. Diese beiden Gehäuseteile bestehen aus einer Aufnahmehülse für den Baustein und aus einer in unterschiedlichem Axialabstand demgegenüber verrastbaren Verschlußdeckel. Um eine einwandfreie Kontaktierung aller anfallenden unterschiedlichen Bausteine an einem einheitlichen, mit elektrischen Leitungen ausgerüsteten Sockelteil des Anschlußgehäuses zu ermöglichen, wird man die Lage der zum Baustein gehörenden Kontakte in der Aufnahmehülse durch radiale Zentrierstützen sowie axiale Endanschläge festlegen. Die so vorbestimmte Position der Kontakte sichert eine einwandfreie Verbindung mit den im Sockelteil integrierten Gegenkontakten, welche an die elektrischen Leitungen angeschlossen sind. Die sich daraus ergebenden unterschiedlichen Füllungen der Aufnahmehülse durch die verschiedenen Bausteine werden einfach durch den Verschlußdeckel ausgeglichen, indem man aus einer vorgegebenen Schar von Rastnasen auf der Außenseite der Aufnahmehülse diejenige zum Eingriff mit der Rastaufnahme eines am Verschlußdeckel vorgesehenen Schließarms bringt, bei welcher der Verschlußdeckel den individuell anfallenden Leerraum in der Aufnahmehülse ausfüllt und mit seinem Deckelinneren sich am Oberende des aufgenommenen Bausteins abstützt. Je nach Auswahl der benutzten Rastnase wird der Verschlußdeckel mehr oder weniger tief ins Innere der Aufnahmehülse eingreifen und dabei für eine rüttelsichere Position des Bausteins im Hülseninneren sorgen.

Um die Auswahl der richtigen Rastnase zu vereinfachen, empfiehlt es sich, die Nasenschar in seitlichem Versatz zueinander anzuordnen, so daß sie den in Anspruch 2 angeführten Zahnkranz auf einem Umfangsbereich der Aufnahmehülse erzeugen. Dabei sollten die Rastnasen nach der Größe ihres zueinander unterschiedlichen Axialabstands geordnet sein und damit die in Anspruch 3 erwähnte Wendel-Anordnung aufweisen, weil damit die Auswahl der richtigen Rastnase sehr einfach durch eine Drehbewegung des Verschlußdeckels im Dichtkragen der Aufnahmehülse möglich ist. Der Schließarm wandert dabei von Nase zu Nase, bis er die jeweils im richtigen Axialabstand befindliche findet. Um den Übergang zwischen den einzelnen Rastnasen zu erleichtern, könnte man den Schließarm radial federnd ausbilden, so daß er von selbst spreizbeweglich von Nase zu Nase springt. Vorteilhaft ist es dabei Profilierungen der Rastnase mit Auflaufschrägen gemäß Anspruch 4 vorzusehen. Diese bestimmen dann eine bevorzugte Drehrichtung des Verschlußdeckels in der Aufnahmehülse.

Um diese Bewegung des Verschlußdeckels beim Drehen selbsttätig zur Ausführung kommen zu lassen, empfiehlt es sich erfindungsgemäß auch noch Führungsnocken an den Schließarmen gemäß Anspruch 5 vorzusehen, welche mit Radialschultern an der Aufnahmehülse zusammenwirken. Diese Radialschultern verlaufen parallel zum Anordnungsmuster der Rastnasen-Schar, nämlich insbesondere wendelförmig. Daraus ergibt sich eine Art Schraubverbindung zwischen Deckel und Gehäuse, die durch die Eingriffsbeziehung zwischen der richtigen Nase und ihrer Rastaufnahme im Schließarm die benötigte Schraubtiefe dauerhaft sichert. Diese Ausführung läßt sich durch eine an der Aufnahmehülse befindliche, vorzugsweise damit einstückige Muffe nach Anspruch 6 vereinfachen.

Sollte der Verschlußdeckel nur in einer bestimmten Ausgangsdrehlage mit der Aufnahmehülse gekuppelt werden können, so kann man hierfür Durchführkanäle für die Führungsnocken der Schließarme nach Anspruch 7 nutzen. Diese Ausgangsdrehlage sollte dabei stets den Rastnocken mit dem kürzesten Radialabstand nach Anspruch 8 ausgerichtet sein. Nützlich ist dabei die Gestaltung gemäß Anspruch 9, denn durch anfängliches axiales Ineinanderschieben erhält man bereits die Verrastung des größstmöglichen Hülseninnenraums, ohne daß die Teile noch von Hand zusammengehalten werden müßten. Von dieser Ausgangsverrastung aus läßt sich dann stufenweise der Verschlußdeckel schrittweise tiefer in die Aufnahmehülse einführen, was durch einfache Drehbewegung möglich ist. Die Rastaufnahme am Verschlußdeckel schnappt dabei von Nase zu Nase, bis sie durch Andruck am aufgenommenen Baustein die endgültige Tiefe des Verschlußdeckels im Hülseninneren findet.

Um ein Verkanten zwischen dem Verschlußdeckel und der Aufnahmehülse auszuschließen, wird man die beschriebenen Rasthaltungen, gemäß Anspruch 10, mehrfach über den Umfang der Aufnahmehülse verteilt anordnen. Es genügen erfahrungsgemäß aber bereits zwei diametral gegenüberliegende Schließarme mit entsprechend zugeordneten Scharen von Rastnasen, Radialschultern und Durchführkanälen. Eine einfache Rastaufnahmen-Form ergibt sich durch die Maßnahme nach Anspruch 11. Bewährt hat sich dabei die Ausbildung des Verschlußdeckels entsprechend Anspruch 12 bis 14.

Von unabhängiger erfinderischer Bedeutung ist es, die Zentrierstützen als Federzungen gemäß Anspruch 15 auszubilden, weil damit eventuelle radiale Freiräume bei Verwendung unterschiedlicher Baustein-Typen selbsttätig ausgeglichen werden. Die Form und Anzahl der Federzungen sollte gemäß Anspruch 16 und 17 ausgebildet sein. Bewährt hat sich die einstückige Ausbildung gemäß Anspruch 18. Zur Erhöhung der Festigkeit kann man Versteifungsrippen gemäß Anspruch 19 verwenden und zwecks Materialersparnis und damit weiterer Verbilligung des Produktes Höhlungen nach Anspruch 20 nutzen.

Weitere Maßnahmen und Vorteile der Erfindung ergeben sich aus den Zeichnungen und der nachfolgenden Beschreibung. Die Erfindung richtet sich dabei auf alle daraus entnehmbaren neuen Merkmale und Merkmalskombinationen, auch wenn diese nicht ausdrücklich in den Unteransprüchen angeführt sein sollten. In den Zeichnungen ist die Erfindung in einem Ausführungsbeispiel dargestellt. Es zeigen:
- Fig. 1: in einer Explosionsdarstellung und Seitenansicht die Bestandteile des erfindungsgemäßen Anschlußgehäuses vor ihrer Verbindung,
- Fig. 2: in starker Vergrößerung und im Axialschnitt zwei miteinander verbundene Gehäuseteile mit einem damit noch unverbundenen dritten Teil,
- Fig. 3: einen Axialschnitt durch den mittleren Gehäuseteil von Fig. 1 längs der dortigen Schnittlinie III-III unter Weglassung des dort aufgenommenen elektrischen Bausteins,
- Fig. 4: eine Stirnendansicht auf das mittlere Gehäuse von Fig. 1 in Blickrichtung IV mit angedeuteter Position eines elektrischen Bausteins,
- Fig. 5: die vergrößerte Innenansicht eines Bestandteils des in Fig. 1 linken Gehäuseteils,
- Fig. 6: die innere Draufsicht auf das linke Gehäuseteil von Fig. 1 in Blickrichtung VI,
- Fig. 7: ein Detail der miteinander gekuppelten beiden Gehäuseteile von Fig. 2 in Draufsicht,
- Fig. 8: eine Querschnittansicht durch die in Fig. 7 gezeigten Bestandteile längs der Schnittlinie VIII-VIII in einer Ruhelage und
- Fig. 9: in einer der Fig. 8 entsprechenden Darstellung eine Zwischenposition der beiden Bestandteile während ihrer manuellen Betätigung.

Das gesamte Anschlußgehäuse besteht aus drei Gehäuseteilen, nämlich einem Sockelteil 10, einer Aufnahmehülse 20 mit daran einstückig angeformter Muffe 30 und einem Verschlußdeckel 40. Der Sockelteil 10 dient zum Anschluß von nicht näher gezeigten elektrischen Leitungen, die vorzugsweise in Fahrzeugen vorgesehen sind, an welche ein elektrischer Baustein, nämlich insbesondere ein Relais 50, angeschlossen werden soll. Dazu besitzt der Sockelteil 10 die Leitungsenden aufnehmenden Axialbohrungen 11, an welche sich nicht näher gezeigte Gegenkontakte aufnehmende Kammern 12 anschließen, die von der Stirnfläche 13 aus zugänglich sind. Der Sockelteil 10 kann von an sich bekannter Bauweise sein und eine Umfangsdichtung 14 aufweisen, die im Kupplungsfall dichtwirksam in das Rohrinnere 15 eines Rohrstücks 16 der zugehörigen Aufnahmehülse 20 eingreifen kann. Dabei sollen die Gegenkontakte in den Kammern 12 mit zum Baustein 50 gehörenden Kontakten 51 in elektrische Verbindung gelangen, die beim montierten Baustein 50 in einer definierten Position im Rohrinneren 15 zu liegen kommen. Dazu wird der Sockelteil 10 in das Rohrstück 16 axial eingeführt, wobei die Einführlage durch einen Schnappverschluß 17, 18 gesichert wird, nämlich einem Paar von diametralen Federhaken 17 am Sockelteil 10 und einem auf der Umfangsfläche des Rohrstücks 16 vorgesehenen Verschlußzahn-Paar 18, das jeweils in eine Öffnung 19 des zugehörigen Hakens 17 einschnappt.

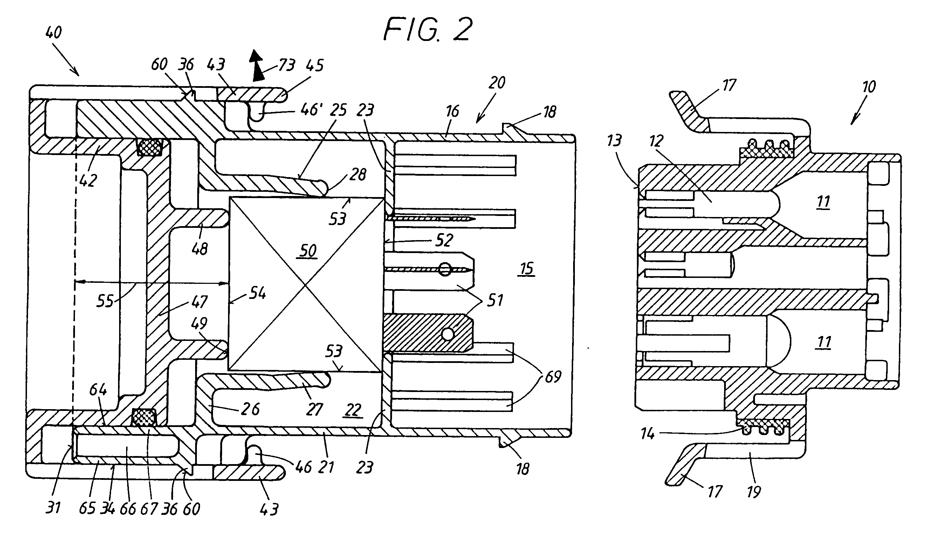

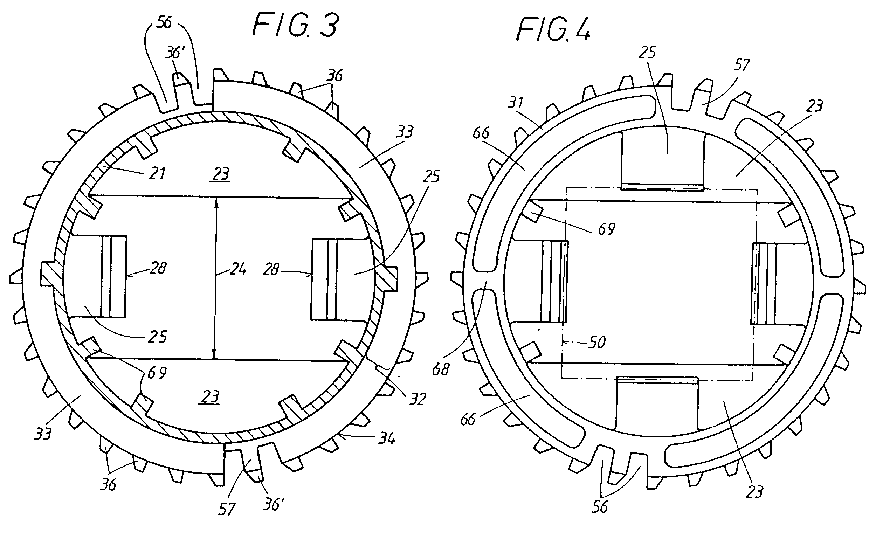

Das zur Aufnahmehülse 20 gehörende Rohrstück 16 setzt sich in einer Hülsenwand 21 fort, die einen veränderlichen, zur Aufnahme des elektrischen Bausteins 50 dienenden Hülsenraum 22 umgrenzt. Der Hülseninnenraum 22 ist gegenüber dem äußeren Rohrraum 15 durch Trennwände 23 geschieden, welche axiale Endanschläge für das aus Fig. 2 erkennbare Unterende 52 des Bausteins 50 bilden und damit für eine definierte Eingriffslage der Bausteinkontakte 51 im Rohrraum 15 sorgen. Wie aus Fig. 3 erkennbar ist, befindet sich zwischen den Trennwandteilen 23 ein ausreichender Durchlaß 24 für die Kontakte 51. In zueinander diametraler Lage sind an der Innenfläche der Hülsenwand 21 jeweils ein Paar von Federzungen 25 mit L-förmigem Längsverlauf angeformt. An der Hülsenwand 21 sitzt, hier in radialer Anordnung, ein kurzer L-Schenkel 26, der in einen demgegenüber radial ausfedernden langen L-Schenkel 27 übergeht und mit seinem Zungenende 28 die Aufgabe hat, nachgiebig an den unterschiedlich dimensionierten Seitenflächen 53 des Bausteins 50 nachgiebig zur Anlage zu kommen. Im vorliegenden Fall handelt es sich um einen rechteckförmigen Baustein 50, weshalb vier, aus Fig. 4 ersichtliche Federzungen 25 in zueinander kreuzförmiger Anordnung vorgesehen sind. Die radial nachgiebigen Zungenenden 28 bestimmen die radiale Anpassung des Hülseninnenraums 22 an den jeweils genutzten Baustein 50. Im Zusammenhang mit den erwähnten Endanschlägen 23 nimmt damit jeder Baustein 50 eine axial und radial ausgerichtete Position im Hülseninneren 22 ein.

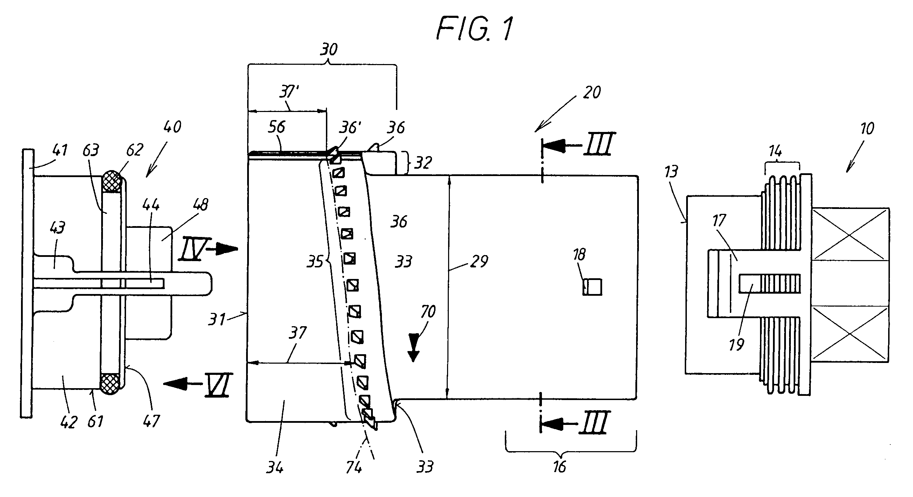

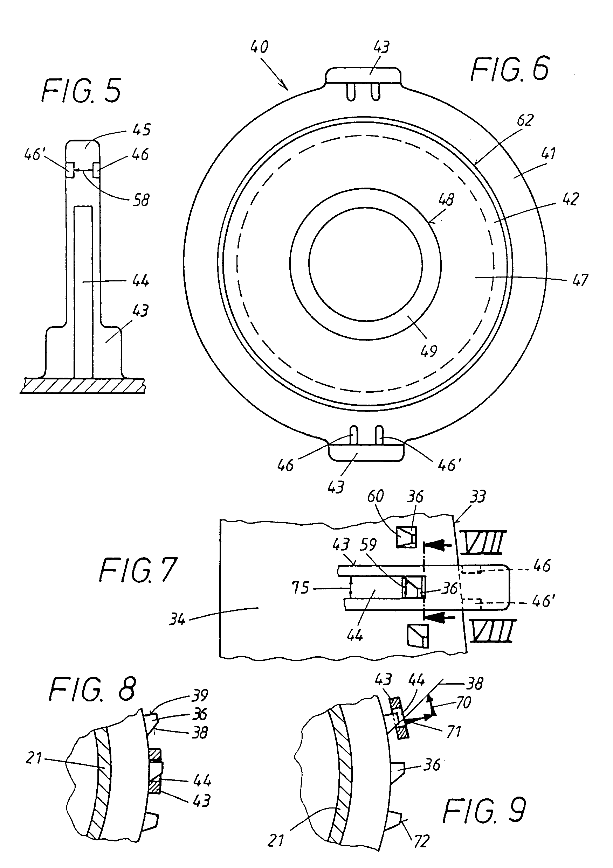

An der Hülsenstirnöffnung 31, die dem Rohrstück 16 gegenüberliegt, beginnt die bereits erwähnte Muffe 30. Die Muffe 30 ist gegenüber dem Hülsendurchmesser 29 radial verbreitert und besitzt an ihrer der Stirnfläche 31 abgekehrten Seite eine besondere Absatzfläche 32, die eine wendelförmig ansteigende Radialschulter 33 in zwei konformen Wendelgängen erzeugt, die sich jeweils über eine halbe Umfangsfläche 34 der Muffe 30 erstrecken. In einem dazu jeweils parallelen Verlauf ist die Umfangsfläche 34 mit einer Schar 35 von Rastnasen 36 versehen, deren Anordnung also ebenfalls zwei miteinander konforme Wendelgänge 74 von Rastnasen 36 gemäß Fig. 1 bestimmt. Die Rastnasen 36 haben folglich einen zueinander unterschiedlichen Axialabstand 37 bezüglich der Muffenstirnfläche 31, wobei jede Wendel-Schar 35 mit einer Rastnase 36' mit dem kürzesten Axialabstand 37' beginnt. Die Rastnasen 36, 36' haben ein zueinander übereinstimmendes Profil, das sägezahnartig ausgebildet ist, bestehend aus einer in Wendelverlaufsrichtung angeordneten geneigten Auflaufschräge 38 und einem davon abgekehrten Steilabfall 39, wie insbesonder aus Fig. 8 und 9 zu entnehmen ist.

Der dritte Gehäuseteil besteht aus dem Verschlußdeckel 40, der sich gliedert in einen Endflansch 41 mit daran angeformtem Napf 42 einerseits und einem Paar von radial federnden, am Endflansch 41 angeformten Schließarmen 43 andererseits. Die Schließarme 43 sind in zueinander diametraler Lage angeordnet und verlaufen achsparallel zur Aufnahmehülse 20. Jeder Schließarm 43 besitzt ein als Rastaufnahme fungierendes Fenster 44, welches als Axialschlitz ausgebildet ist. Wie aus Fig. 7 entnehmbar ist, liegt dabei eine lichte Fensterbreite 75 vor, die größer/gleich der Profilbreite 59 einer Rastnase 36 ausgebildet ist und daher mit dieser in Eingriff kommen kann. Im Bereich des freien Armendes 45 besitzt der Schließarm 43 einen in zwei Glieder 46, 46' geteilten Führungsnocken, der zum dazwischenliegenden Napf 42 hin gerichtet ist. Am Napfboden 47 ist in axialer Ausrichtung ein Zylinderansatz 48 angeformt, der ein zentrales Druckstück bildet, weil in der aus Fig. 2 ersichtlichen Einstecklage des Verschlußdeckels 40 seine Zylinderendfläche 49 druckwirksam am Oberende 54 des im Hülseninneren 22 aufgenommenen Bausteins 50 zur Anlage kommt. Dabei kommt der Verschlußdeckel 40 in einer der Dimension des Bausteins 50 angepaßten fallweise unterschiedlichen axialen Tiefe 55 in der Aufnahmehülse 20 zu liegen, wie aus Fig. 2 zu entnehmen ist. Dies vollzieht sich im einzelnen in folgender Weise:
Die Muffenumfangsfläche 34 ist mit einem als Doppelnut ausgebildeten Durchführkanal 56 axial durchzogen, der von der Muffenstirnfläche 31 ausgeht und jeweils im Bereich der Rastnase 36' mit dem kürzesten Axialabstand 37' an der wendelförmigen Radialschulter 33 ausmündet. Die Füllung in der Doppelnut kommt dabei durch einen Zwischensteg 57 zustande, welche die erwähnte axial kürzeste Rastnase 36' trägt. Nachdem der ausgewählte Baustein 50 im Hülseninneren 22 in der beschriebenen Weise zwischen den sich auseinanderspreizenden Federzungen 25 positioniert worden ist, kann nun der Verschlußdeckel 40, beginnend mit seinen Schließarmen 43, axial über die Muffe 30 der Aufnahmehülse 20 geschoben werden. Dabei fahren die auf der Unterseite der beiden Schließarme 43 befindlichen Nockenglieder 46, 46' in die Doppelnut des Durchführkanals 56 ein, denn die beiden Nockenglieder 46, 46' sind, gemäß Fig. 5, in einem seitlichen Abstand 58 zueinander angeordnet, welche der Stärke des Zwischenstegs 57 in der Doppelnut 56 entspricht. Das freie Armende 45 fährt dabei auf eine in Axialrichtung ansteigende Neigungsfläche 60 im Profil der Rastnase 36' auf und wird radial gegenüber der Hülse 20 gespreizt, bis schließlich das als Rastaufnahme fungierende Fenster 44 erreicht ist, wo hinein diese anfängliche Rastnase 36' schnappt. Es liegt dann die Ausgangsstellung des in der Muffe 30 eingesteckten Verschlußdeckels 40 vor.

Bereits in dieser Ausgangsstellung ist der Verschlußdeckel 40 dichtwirksam in die Muffe 30 eingeführt. Wie aus Fig. 1 entnehmbar, besitzt die Napfseitenwand 61 einen eingelassenen Dichtungsring 62, der im dargestellten Ausführungsbeispiel in einer umlaufenden Außennut 63 des Verschlußdeckels 40 ruht. In Fig. 1 ist der Dichtungsring 62 der besseren Deutlichkeit wegen radial geschnitten dargestellt. Anstelle einer solchen Außennut 63 könnte auch ein Radialabsatz vorliegen, der ausgeschäumt ist und damit die entsprechenden Dichtungswirkungen mit der Muffeninnenfläche 64 erzeugt.

Aus Gründen der Materialersparnis ist die Muffe 30 doppelwandig 65, 67 ausgebildet. die beschriebene Muffenumfangsfläche 34 wird von einer Außenwand 65 gebildet, die durch axiale Höhlungen 66 von einer Innenwand 67 getrennt ist, welche die vorbeschriebene Muffeninnenfläche 64 zur Aufnahme des Deckel-Napfes 42 bildet. Aus Gründen der Festigkeit sind die axialen Höhlungen 66, wie aus Fig. 4 zu entnehmen ist, durch radiale Stege 68 getrennt. Im abschließenden Rohrstück 16 können sich axiale Versteifungsrippen 69 befinden, die bedarfsweise sich im Hülseninnenraum 22 fortsetzen können.

In der vorbeschriebenen Ausgangsstellung nach dem axialen Einstecken des Verschlußdeckels 40 in der Aufnahmehülse 20, gelangen auch die beiden Glieder 46, 46' des Führungsnockens am Ende des Durchführkanals 56 in Ausrichtung mit der wendelförmigen Radialschulter 33 am Muffenabsatz 32. In dieser Ausgangsstellung liegt normalerweise noch nicht die vom aufgenommenen elektrischen Baustein 50 bestimmte endgültige Einstecktiefe 55 vor. Diese wird erst durch nachträgliches Verdrehen des Verschlußdeckels 40 in Steigungsrichtung des Wendelverlaufs 33 erreicht, was in Fig. 1 und 9 durch den Drehpfeil 70 veranschaulicht ist. Dabei hintergreifen, wie aus Fig. 7 hervorgeht, die Glieder des Führungsnockens 46, 46' stets die Radialschulter 33 und wandeln in Steigungsrichtung ihrer Wendelung schrittweise empor. Bereits dabei ist der axiale Zusammenhalt zwischen dem Verschlußdeckel 40 und der Aufnahmehülse 20 gesichert. Beim Übergang zwischen benachbarten Rastnasen 36 spreizt sich aber der Schließarm 43 im Sinne des aus Fig. 9 ersichtlichen Bewegungspfeils 71 selbsttätig ab, denn die eine Fensterkante seiner Aufnahme gleitet, wie durch die Hilfslinie 38 in Fig. 9 verdeutlicht ist, an der Auflaufschräge 38 empor, bis schließlich der abgespreizte Schließarm 43 sich über die Nasenkuppe 72 hinwegbewegen kann, um dann in entsprechender Spreizbewegung an der nachfolgenden Rastnase 36 emporzuwandern, bis schließlich diese nächste Rastnase 36 das als Rastaufnahme fungierende Fenster 44 im Schließarm 43 erreicht hat. Die beiden Glieder des Führungsnockens 46, 46' können dabei eine radiale Höhe aufweisen, die sie während der gesamten Spreizbewegung 71 der Schließarme 43 die wendelförmige Radialschulter 33 hintergreifen läßt.

Wie ersichtlich, wird durch die beschriebene Drehbewegung 70 des Verschlußdeckels 40 dieser schraubenartig immer weiter ins Muffeninnere hineinbewegt, wobei eine der Drehbewegung 70 entgegengerichtete ungewollte Rückdrehung durch Anlage des jeweils maßgeblichen Steilabfalls 39 am Fenster 44 des Schließarms 43 verhindert wird. Bei seinem Verdrehen 70 gelangt somit der Verschlußdeckel 40 zunehmend in eine größere Einstecktiefe 55, bis schließlich die Anpreßlage seines als Druckstück fungierenden Zylinderansatzes 48 am Baustein 50 gemäß Fig. 2 erreicht ist. Die selbsttätig wirksame Abspreizbewegung der Schließarme 43 macht sich in einem Klickgeräusch für die Bedienungsperson kundbar. Die erreichte Einstecktiefe 55 begrenzt den individuell zur Aufnahme des Bausteins 50 benötigten Hülseninnenraum 22. Der axiale und radiale Zusammenhalt zwischen dem Verschlußdeckel 40 und der Aufnahmehülse 20 ist gesichert.

Will man den montierten Baustein 50 ersetzen, weil er z. B. defekt ist, so kann der Verschlußdeckel 40 von der Muffe 30 mit einem Griff entfernt werden. Im allgemeinen braucht man dabei nicht eine rückläufige Drehung des Verschlußdeckels 40 zu seiner Aufschraubbewegung 70 auszuführen, denn es genügt eine manuelle Auseinanderspreizung im Sinne des Pfeils 71 mit größerem Spreizwinkel, um die beiden Glieder des Führungsnockens 46, 46' aus der wendelförmigen Radialschulter 33 radial auszuheben. Dabei wird auch die im Fenster 44 in Eingriff stehende individuelle Rastnase 36 freigegeben, so daß der Verschlußdeckel 40 von der Aufnahmehülse 20 axial wegbewegt werden kann. Dazu ist es lediglich nötig, den Schließarm 43 an seinem Hinterende 45 zu hintergreifen und im Sinne des Schwenkbewegungspfeils 73 von Fig. 2 radial auszubiegen.

## Patentansprüche

1. Gehäuse zum Anschluß eines elektrischen Bausteins (50), insbesondere eines Relais, an elektrische Leitungen in der Bordelektronik von Fahrzeugen,
bestehend aus einem den elektrischen Baustein (50) halternden Montageteil mit einem die Kontakte (51) des Bausteins umschließenden Rohrstück (16) und aus einem abdichtend in das Rohrstück (16) einführbaren Sockelteil (10), welcher an die elektrischen Leitungen angeschlossene Gegenkontakte (12) beinhaltet,
dadurch gekennzeichnet, daß
der Sockelteil (10) in seiner die Kontakte (51) des Bauteils mit seinen Gegenkontakten (12) kuppelnden Einführlage durch einen Schnappverschluß (17, 18) mit dem Montageteil gesichert ist,
daß ein zweiteiliges, zerlegbares Montageteil (20, 40) zur lösbaren Aufnahme des Bausteins (50) vorgesehen ist,
bestehend aus einer sowohl axiale Endanschläge (23) für das Baustein-Unterende (52) als auch radiale Zentrierstützen (25) für die Baustein-Seitenflächen (53) aufweisenden Aufnahmehülse (20) einerseits
und aus einem in die Aufnahmehülse (20) in wählbarer axialer Tiefe (55) dichtwirksam einsteckbaren Verschlußdeckel (40) andererseits, dessen Deckelinneres (47) ein am Oberende (54) des aufgenommenen Bausteins (50) abstützbares Druckstück (48) ist,
wobei auf der Außenseite (34) der Aufnahmehülse (20) eine Schar (35) von in unterschiedlichem Axialabstand (37) zur Hülsenstirnöffnung (31) angeordneten Rastnasen (36) sich befinden,
während der Verschlußdeckel (40) wenigstens einen im Einsteckfall die Aufnahmehülse (20) übergreifenden Schließarm (43) mit einer Rastaufnahme (44) trägt, welche mit einer ausgewählten Rastnase (36) der Nasenschar (35) kuppelbar ist.

2. Anschlußgehäuse nach Anspruch 1, dadurch gekennzeichnet, daß die Rastnasen (36) als Zahnkranz (35) über wenigstens einen Umfangsbereich (34) der Aufnahmehülse (20) verteilt angeordnet sind und der eingesteckte Verschlußdeckel (40), mit seinem Schließarm (43) von Nase (36) zu Nase wandernd, in der Aufnahmehülse verdrehbar (70) ist.

3. Anschlußgehäuse nach Anspruch 2, dadurch gekennzeichnet, daß der Kranz (35) der Rastnasen (36) in Form einer Wendel (74) angeordnet ist, der axial verlaufende Schließarm (43) radial federnd (73) ausgebildet ist und bezüglich der Aufnahmehülse (20) mindestens im Ausmaß der Rastnasen-Höhe abspreizbar (71) ist.

4. Anschlußgehäuse nach Anspruch 3, dadurch gekennzeichnet, daß die Rastnasen (36) ein sägezahnartiges Profil (38, 39) aufweisen mit einer in Steigungsrichtung der Wendel (74) weisenden Auflaufschräge (38) für die Rastaufnahme (44) des Schließarms (43), wobei die Auflaufschräge (38) die Drehrichtung (70) des in der Aufnahmehülse (20) eingesteckten Verschlußdeckels (40) bestimmt.

5. Anschlußgehäuse nach einen, der Ansprüche 1 bis 4, dadurch gekennzeichnet, daß der Schließarm (43) im Bereich seines freien Armendes (45) einen Führungsnocken (46, 46') aufweist, der im Einsteckfall des Verschlußdeckels (40) eine an der Umfangsfläche (34) der Aufnahmehülse (20) befindliche Radialschulter (33) hintergreift und die Radialschulter (33) im wesentlichen parallel zum Anordnungsmuster (74) der Rastnasen-Schar (35) verläuft, und zwar insbesondere wendelförmig gestaltet ist.

6. Anschlußgehäuse nach Anspruch 5, dadurch gekennzeichnet, daß die Aufnahmehülse (20) an ihrer Stirnöffnung (31) mit einer gegenüber dem Hülsendurchmesser (29) abgesetzten, radial verbreiterten Muffe (30) versehen ist, deren Muffeninneres (64) zur Steckaufnahme des Verschlußdeckels (40) dient und deren äußere Absatzfläche (32) die wendelförmige Radialschulter (33) für die Führungsnocken (46, 46') der Schließarme (43) erzeugt.

7. Anschlußgehäuse nach Anspruch 6, dadurch gekennzeichnet, daß die Muffe (30) auf ihrer Umfangsfläche (34) mit vorzugsweise axial verlaufenden Durchführkanälen (56) für die Führungsnocken (46, 46') der Schließarme (43) versehen ist, die von der Muffenstirnfläche (31) aus bis zu der die Radialschulter (33) erzeugenden Absatzfläche (32) durchgehen.

8. Anschlußgehäuse nach Anspruch 7, dadurch gekennzeichnet, daß der Durchführkanal (56) im Bereich des den kürzesten Axialabstand (37') zur Muffenstirnfläche (31) aufweisenden Rastnase (36') angeordnet ist.

9. Anschlußgehäuse nach einem der Ansprüche 5 bis 8, dadurch gekennzeichnet, daß ein Schließarm (43) jeweils einen zweigliedrigen Führungsnocken (46, 46') aufweist, die beiden Nockenglieder (46, 46') in einem seitlichen, die Profilbreite einer Rastnase übersteigenden Abstand (58) zueinander angeordnet sind, der Durchführkanal (56) aus einer durch einen Zwischensteg (57) geteilten Doppelnut für die beiden Nockenglieder (46, 46') besteht und der Zwischensteg (57) den Rastnocken (36') mit dem kürzesten Radialabstand (37') bezüglich der Muffenstirnfläche (31) trägt.

10. Anschlußgehäuse nach einem der Ansprüche 1 bis 9, dadurch gekennzeichnet, daß der Verschlußdeckel (40) mehrere, vorzugsweise zwei in zueinander diametraler Position angeordnete Schließarme (43) trägt und an der Aufnahmehülse (20) jedem Schließarm (43) eine eigene Schar (35) von Rastnasen (36) in konformer Abstandslage (37) und ggf. Radialschultern (33) mit eigenem Wendelgang sowie ein Durchführungskanal (56) für die zugehörigen Führungsnocken (46, 46') zugeordnet sind.

11. Anschlußgehäuse nach einem der Ansprüche 1 bis 10, dadurch gekennzeichnet, daß die Rastaufnahme aus einem vorzugsweise als Axialschlitz gestalteten Fenster (44) im Schließarm (43) besteht, welches eine lichte Fensterbreite (75) aufweist, die größer/gleich der Profilbreite (58) einer Rastnase ausgebildet ist.

12. Anschlußgehäuse nach einem der Ansprüche 1 bis 11, dadurch gekennzeichnet, daß der Verschlußdeckel (40) aus einem ins Muffen- bzw. Hülseninnere (64) einsteckbaren Napf (42) besteht, dessen Napfboden (47) das am Oberende (54) des Bausteins (50) sich abstützende Druckstück (48) trägt.

13. Anschlußgehäuse nach Anspruch 12, dadurch gekennzeichnet, daß das Druckstück aus einem koaxial in der Aufnahmehülse (20) zu liegen kommenden Zylinderansatz (48) besteht, dessen Zylinderendfläche (49) druckwirksam ist.

14. Anschlußgehäuse nach Anspruch 12 oder 13, dadurch gekennzeichnet, daß die Napfseitenwand (61) eine umlaufende Außennut (63) bzw. einen Außenabsatz für einen Dichtungsring (62) aufweist.

15. Anschlußgehäuse nach einem der Ansprüche 1 bis 14, dadurch gekennzeichnet, daß die Zentrierstützen für den Baustein (50) aus radial federnden Zungen (25) bestehen, die mit ihren Zungenenden (28) nachgiebig an den Seitenflächen (53) des im Hülseninneren (22) aufgenommenen Bausteins (50) anliegen.

16. Anschlußgehäuse nach Anspruch 15, dadurch gekennzeichnet, daß die Federzungen (25) einen L-förmigen Längsverlauf aufweisen, mit ihrem kurzen L-Schenkel (26) an der Hülsenwand (21) sitzen und mit ihrem langen L-Schenkel (27) demgegenüber radial federnd sind.

17. Anschlußgehäuse nach Anspruch 15 oder 16, dadurch gekennzeichnet, daß bei rechteckigem Umriß des Bausteins (50) vier, paarweise einander diametral gegenüberliegende Federzungen (25) im Hülseninneren (22) vorgesehen sind.

18. Anschlußgehäuse nach einem der Ansprüche 15 bis 17, dadurch gekennzeichnet, daß die Federzungen (25) einstückig mit der Aufnahmehülse (20) ausgebildet sind.

19. Anschlußgehäuse nach einem der Ansprüche 1 bis 18, dadurch gekennzeichnet, daß die Aufnahmehülse (20) mit inneren, vorzugsweise axial verlaufenden Versteifungsrippen (69) versehen ist.

20. Anschlußgehäuse nach einem der Ansprüche 1 bis 19, dadurch gekennzeichnet, daß die Muffe (30) eine durch axiale Höhlungen (66) von ihrer Außenwand (65) getrennte Innenwand (67) besitzt, die sich in der anschließenden, damit einstückigen Hülsenwand (21) fortsetzt.

## Claims

1. A casing for connecting an electric component (50), particularly a relay, to electric vehicle dashboard conductors,
comprising an assembly part holding said electric component (50) with a tube section (16) enclosing the contacts (51) of said component, and comprising a base part (10), which may be inserted into said tube section (16) to form a seal and contains cooperating contacts (12) connected to said electric conductors,
characterised in that in its insert position, in which it couples said contacts (51) of said component with its cooperating contacts (12) , said base part (10) is secured by a snap seal (17, 18) to said assembly part;
that a two-part separable assembly part (20, 40) is provided to detachably receive said component (50),
comprising a receiving sleeve (20) having both axial end stops (23) for the lower end (52) of said component and radial centring supports (25) for the side surfaces (53) of said component, as well as
comprising a sealing cover (40), which may be inserted to a selected axial depth (55) into said receiving sleeve (20) to form a seal, the interior (47) of said cover being a pressure plate (48), which may be supported on the upper end (54) of the housed component (50),
wherein a group (35) of detents (36) arranged at varying axial distance (37) from the front opening (31) of said sleeve is located on the outside (34) of said receiving sleeve (20),
said sealing cover (40) being provided with at least one closing arm (43), which engages across said receiving sleeve (20) when plugged-in, with a catch cavity (44) which may engage with a selected detent (36) from the group (35).

2. A casing according to Claim 1, characterised in that the detents (36) are distributed in the form of a toothed ring (35) over at least one peripheral section (34) of the receiving sleeve (20) and the plugged-in sealing cover (40), with its closing arm (43) shifting from detent (36) to detent, is rotatable (70) in said receiving sleeve.

3. A casing according to Claim 2, characterised in that the ring (35) of detents (36) is arranged in the form of a spiral (74), the axially extending closing arm (43) is radially flexible (73) and may be stayed (71) in relation to the receiving sleeve (20) at least to the overall dimension of the detent height.

4. A casing according to Claim 3, characterised in that the detents (36) have a saw tooth-like profile (38, 39) with an upward incline (38) pointing in the direction of ascent of the spiral (74) for the catch cavity (44) of the closing arm (43), said upward incline (38) determining the direction of rotation (70) of the sealing cover (40) plugged into the receiving sleeve (20).

5. A casing according to one of Claims 1 to 4, characterised in that the closing arm (43) is provided with a guide cam (46, 46') in the area of its free end (45), which, when the sealing cover (40) is plugged in, engages behind a radial shoulder (33) located on the peripheral surface (34) of the receiving sleeve (20) and said radial shoulder (33) runs essentially parallel to the assembly pattern (74) of the group (35) of detents, arranged in particular in the form of a spiral.

6. A casing according to Claim 5, characterised in that the receiving sleeve (20) is provided at its front opening (31) with a radially widened socket (30), which is offset in relation to the sleeve diameter (29), the interior (64) of said socket being provided for the plug connection of the sealing cover (40) and its outer offset surface (32) forming the spiral radial shoulder (33) for the guide cams (46, 46') of the closing arms (43).

7. A casing according to Claim 6, characterised in that the peripheral surface (34) of the socket (30) is provided with preferably axially extending ducts (56) for the guide cams (46, 46') of the closing arms (43), which pass through from the face (31) of the socket to the offset surface (32) forming the radial shoulder (33).

8. A casing according to Claim 7, characterised in that the duct (56) is arranged in the area of the detent (36') at the shortest axial distance (37') from the face (31) of the socket.

9. A casing according to one of Claims 5 to 8, characterised in that each closing arm (43) has a two-member guide cam (46, 46'), the two cam members (46, 46') being arranged at a lateral distance (58) from one another which exceeds the profile width of a detent, the duct (56) comprises a double groove divided by an intermediate web (57) for said two cam members (46, 46') and said intermediate web (57) supports the detent (36') at the shortest radial distance (37') from the face (31) of the socket.

10. A casing according to one of Claims 1 to 9, characterised in that the sealing cover (40) is provided with several, preferably two, diametrically arranged closing arms (43) and each closing arm (43) has its own group (35) of detents (36) arranged at an appropriate distance (37) on the receiving sleeve (20), and optionally has radial shoulders (33) with their own spiral form as well as a duct (56) for the respective guide cams (46, 46').

11. A casing according to one of Claims 1 to 10, characterised in that the catch cavity comprises an aperture (44) in the closing arm (43) preferably in the form of an axial slot with an inner aperture width (75) which is greater than/equal to the profile width (58) of a detent.

12. A casing according to one of Claims 1 to 11, characterised in that the sealing cover (40) comprises a bowl (42) which may be plugged into the interior (64) of the socket or sleeve, the base (47) of said bowl holding the pressure plate (48) supported at the upper end (54) of the component (50).

13. A casing according to Claim 12, characterised in that the pressure plate comprises a cylinder attachment (48) resting coaxially in the receiving sleeve (20), the end surface (49) of said cylinder attachment forming a pressure source.

14. A casing according to Claim 12 or 13, characterised in that the side wall (61) of the bowl has a peripheral outer groove (63) or an outer shoulder for a sealing ring (62).

15. A casing according to one of Claims 1 to 14, characterised in that the centring supports for the component (50) comprise radially flexible tongues (25), the tongue ends (28) of which flexibly abut the side surfaces (53) of said component (50) housed in the interior (22) of the sleeve.

16. A casing according to Claim 15, characterised in that the flexible tongues (25) have an L-shaped longitudinal extension, their short L-leg (26) being supported on the sleeve wall (21) and their long L-leg (27) being radially flexible in relation thereto.

17. A casing according to Claim 15 or 16, characterised in that where the component (50) has a rectangular contour, four flexible tongues (25) in pairs diametrically opposed to one another are provided in the interior (22) of the sleeve.

18. A casing according to one of Claims 15 to 17, characterised in that the flexible tongues (25) are integral with the receiving sleeve (20).

19. A casing according to one of Claims 1 to 18, characterised in that the receiving sleeve (20) is provided with internal reinforcing ribs (69), preferably extending axially.

20. A casing according to one of Claims 1 to 19, characterised in that the socket (30) is provided with an internal wall (67), which is separated from its external wall (65) by axial cavities (66) and which is continued in the adjoining, and therefore integral sleeve wall (21).

## Revendications

1. Boitier pour la connexion d'un composant électrique (50), en particulier d'un relais, à des conducteurs électriques intégrés dans le circuit électronique de bord de véhicules,
constitué d'une partie de montage qui retient le composant électrique (50), et présente une pièce tubulaire (16) entourant les contacts (51) du composant, et d'un culot (10) qui peut être introduit de manière étanche dans la pièce tubulaire (16), et renferme des contacts complémentaires (12) raccordés aux conducteurs électriques,
caractérisé par le fait que, dans sa position d'introduction accouplant les contacts (51) du composant à ses contacts complémentaires (12), le culot (10) est assujetti à la partie de montage par l'intermédiaire d'une fermeture à déclic (17, 18),
et par le fait qu'il est prévu, pour recevoir le composant (50) de manière libérable, une partie de montage (20, 40) comprenant deux pièces, pouvant être dissociée,
et constituée, d'une part, d'une douille réceptrice (20) comportant à la fois des butées extrêmes axiales (23) pour l'extrémité inférieure (52) du composant, et des appuis radiaux de centrage (25) pour les faces latérales (53) dudit composant
et, d'autre part, d'un couvercle obturateur (40) qui exerce un effet d'étanchement, peut être emboîté dans la douille réceptrice (20) avec profondeur axiale sélectionnable (55), et dont l'espace interne (47) est une pièce de pression (48) pouvant prendre appui sur l'extrémité supérieure (54) du composant (50) incorporé,
boîtier dans lequel se trouve, sur la face externe (34) de la douille réceptrice (20), un groupe (35) de becs encliquetables (36) situés à un espacement axial (37) différent par rapport à l'ouverture frontale (31) de la douille,
tandis que le couvercle obturateur (40) porte au moins un bras de fermeture (43) qui vient coiffer la douille réceptrice (20) lors d'un emboîtement, et est muni d'un logement d'encrantage (44) pouvant être accouplé à un bec encliquetable sélectionné (36) du groupe (35) de becs.

2. Boîtier de connexion selon la revendication 1, caractérisé par le fait que les becs encliquetables (36) sont agencés avec répartition, sous la forme d'une couronne de dents (35), sur au moins une région périphérique (34) de la douille réceptrice (20), et le couvercle obturateur emboîté (40) peut tourner (70) dans la douille réceptrice, en se déplaçant d'un bec (36) à l'autre par son bras de fermeture (43).

3. Boîtier de connexion selon la revendication 2, caractérisé par le fait que la couronne (35) des becs encliquetables (36) est agencée sous la forme d'une hélice (74), le bras de fermeture (43), s'étendant axialement, étant réalisé doué d'élasticité (73) dans le sens radial et pouvant être écarté (71), par rapport à la douille réceptrice (20), au moins en concordance avec la hauteur des becs encliquetables.

4. Boîtier de connexion selon la revendication 3, caractérisé par le fait que les becs encliquetables (36) présentent un profil en dents de scie (38, 39) muni, pour le logement d'encrantage (44) du bras de fermeture (43), d'une rampe ascendante (38) orientée dans le sens du pas de l'hélice (74), la rampe ascendante (38) déterminant le sens de rotation (70) du couvercle obturateur (40) emboîté dans la douille réceptrice (20).

5. Boîtier de connexion selon l'une des revendications 1 à 4, caractérisé par le fait que le bras de fermeture (43) comporte, dans la région de son extrémité libre (45), une came de guidage (46, 46') qui, lors d'un emboîtement du couvercle obturateur (40), emprisonne par-derrière un épaulement radial (33) situé sur la surface périphérique (34) de la douille réceptrice (20), l'épaulement radial (33) s'étendant pour l'essentiel parallèlement à la configuration (74) du groupe (35) de becs encliquetables, et étant notamment conformé en une hélice.

6. Boîtier de connexion selon la revendication 5, caractérisé par le fait que la douille réceptrice (20) est pourvue à son ouverture frontale (31), d'un manchon (30) élargi dans le sens radial et présentant un gradin par rapport au diamètre (29) de la douille, manchon dont l'espace interne (64) sert à recevoir le couvercle obturateur (40) par emboîtement, et dont la surface extérieure (32) en décrochement donne naissance à l'épaulement radial hélicoïdal (33) destiné aux cames de guidage (46, 46') des bras de fermeture (43).

7. Boîtier de connexion selon la revendication 6, caractérisé par le fait que le manchon (30) est pourvu, sur sa surface périphérique (34), de canaux de guidage (56) qui s'étendent de préférence axialement, sont destinés aux cames de guidage (46, 46') des bras de fermeture (43) et s'étendent, d'un trait, de la face frontale (31) du manchon jusqu'à la surface en décrochement (32) qui donne naissance à l'épaulement radial (33).

8. Boîtier de connexion selon la revendication 7, caractérisé par le fait que le canal de guidage (56) est disposé dans la région du bec encliquetable (36') qui présente l'espacement axial minimal (37') par rapport à la face frontale (31) du manchon.

9. Boîtier de connexion selon l'une des revendications 5 à 8, caractérisé par le fait qu'un bras de fermeture (43) présente, à chaque fois, une came de guidage (46, 46') constituée de deux organes ; les deux organes (46, 46') de la came sont distants l'un de l'autre d'un espacement latéral (58) excédant la largeur du profil d'un bec encliquetable ; le canal de guidage (56) est constitué d'une double gorge destinée aux deux organes (46, 46') de la came, et subdivisée par une membrure intercalaire (57) ; et la membrure intercalaire (57) porte le bec encliquetable (36') présentant l'espacement radial minimal (37') par rapport à la face frontale (31) du manchon.

10. Boîtier de connexion selon l'une des revendications 1 à 9, caractérisé par le fait que le couvercle obturateur (40) porte plusieurs, de préférence deux bras de fermeture (43) occupant des positions diamétralement opposées ; et, sur la douille réceptrice (20), chaque bras de fermeture (43) est associé à un groupe distinct (35) de becs encliquetables (36) situés à des espacements concordants (37), et éventuellement à des épaulements radiaux (33) présentant une propre configuration hélicoïdale, ainsi qu'à un canal de guidage (56) destiné aux cames de guidage correspondantes (46, 46').

11. Boîtier de connexion selon l'une des revendications 1 à 10, caractérisé par le fait que le logement d'encrantage consiste en une fenêtre (44) préférentiellement configurée en une fente axiale dans le bras de fermeture (43), et présentant une largeur intérieure (75) supérieure/égale à la largeur (58) du profil d'un bec encliquetable.

12. Boîtier de connexion selon l'une des revendications 1 à 11, caractérisé par le fait que le couvercle obturateur (40) consiste en un godet (42) pouvant être emboîté dans l'espace interne respectif (64) du manchon ou de la douille, et dont le fond (47) porte la pièce de pression (48) prenant appui contre l'extrémité supérieure (54) du composant (50).

13. Boîtier de connexion selon la revendication 12, caractérisé par le fait que la pièce de pression est constituée d'un appendice cylindrique (48) qui vient se placer coaxialement dans la douille réceptrice (20), et dont la face extrême cylindrique (49) exerce une pression.

14. Boîtier de connexion selon la revendication 12 ou 13, caractérisé par le fait que la paroi latérale (61) du godet comporte une saignée circonférentielle externe (63) ou un décrochement externe, respectivement destiné(e) à une bague d'étanchement (62).

15. Boîtier de connexion selon l'une des revendications 1 à 14, caractérisé par le fait que les appuis de centrage destinés au composant (50) consistent en des languettes (25) douées d'élasticité dans le sens radial et venant s'appliquer en souplesse, par leurs extrémités (28), contre les faces latérales (53) du composant (50) logé dans l'espace interne (22) de la douille.

16. Boîtier de connexion selon la revendication 15, caractérisé par le fait que les languettes élastiques (25) possèdent une allure longitudinale configurée en L, reposent contre la paroi (21) de la douille par leur branche (26) de L courte, et sont en revanche douées d'élasticité radiale par leur branche (27) de L longue.

17. Boîtier de connexion selon la revendication 15 ou 16, caractérisé par le fait que, lorsque le composant (50) est de configuration rectangulaire, quatre languettes élastiques (25), diamétralement opposées par paires, sont prévues dans l'espace interne (22) de la douille.

18. Boîtier de connexion selon l'une des revendications 15 à 17, caractérisé par le fait que les languettes élastiques (25) sont réalisées d'un seul tenant avec la douille réceptrice (20).

19. Boîtier de connexion selon l'une des revendications 1 à 18, caractérisé par le fait que la douille réceptrice (20) est pourvue de nervures internes de rigidification (69) s'étendant, de préférence, dans le sens axial

20. Boîtier de connexion selon l'une des revendications 1 à 19, caractérisé par le fait que le manchon (30) possède une paroi intérieure (67) qui est séparée de sa paroi extérieure (65) par des cavités axiales (66), et qui fusionne dans la paroi attenante (21) de la douille, constituant de ce fait un seul tenant.
